# EUROPEAN PATENT APPLICATION

(11) **EP 0 546 768 A1**
(43) Date of publication of application: **16.06.1993**
(21) Application number: 92311043.1
(22) Date of filing: 03.12.1992
(51) Int. Cl.: G03F 7/033

(54) **Water-borne photoimageable compositions**

(30) Priority: 11.12.1991 US 807017
(71) Applicant: MORTON INTERNATIONAL, INC., Chicago, Illinois 60606 (US)
(72) Inventor: Speelman, Brent T., Huntington Beach, California 92646 (US); Shelnut, James G., Northborough, Massachusetts 01532 (US); Flynn, Kathy M., Tustin, California 92680 (US); Eramo, Lincoln, San Clemente, California 92672 (US); Behr, Andrew H., Los Alamitos, California 90720 (US); Neghandi, Nitin J., Covina, California 91723 (US)
(74) Representative: Bankes, Stephen Charles Digby

(57) **Abstract**

A water-borne and aqueous developable photoimageable composition comprises an emulsion binder polymer having an acid number of between 50 and 175 with sufficient surfactant to maintain micelles of said emulsion polymer, a solution binder polymer having an acid number of between 100 and 250, and ammonia or an ammonium compound in an amount sufficient to solubilize said solution in an aqueous medium containing no organic solvent. The composition also includes a photopolymerizable monomer and a photoinitiator.

## Description

The present invention is directed to photoimageable compositions, such as are suitable for use in the printed circuit board industry, and more particularly to photoimageable compositions which are borne in an aqueous medium.

### BACKGROUND OF THE INVENTION

Photoimageable resists have been used in the printed circuit board industry for a considerable time. Photoimageable resists are used almost exclusively to make state-of-the-art printed circuits where high resolution of lines and spaces is required.

This application is specifically directed to negative-acting resists which include polymeric binders, photopolymerizable monomers and/or oligomers and photoinitiators that initiate polymerization of the monomers when exposed to actinic radiation.

In a typical procedure, a blank metal-clad laminate or board for forming a printed circuit board comprises a thin layer of metal covering a non-conductive substrate. A layer of photoresist is applied over the metal layer. The photoresist is exposed to patterned actinic radiation, e.g., by passing illumination through artwork having an opaque/transparent pattern. The exposed photoresist is then developed by exposure to a solution or solvent which washes unexposed portions of the photoresist, leaving a patterned layer of exposed photoresist. The panel can then be etched with a solution which removes the metal layer from those portions of the plate from which photoresist has been removed. Subsequent to etching, the remaining photoresist layer is generally stripped away.

Alternatively, the panel can be pattern plated on a blank non-conducting substrate, whereby the areas devoid of photoresist are electrolessly or electro-chemically plated with copper or the like, the resist is stripped, as disclosed above, and the newly exposed areas are then removed by etching, leaving behind the pattern plated areas.

In early photoresists of this type, the components of the photoresist were dissolved in solvent and applied to the blank metal-clad board for the printed circuit board. Evaporation of the solvent left a film on the surface of the blank metal-clad board. After exposure to actinic radiation, the photoresist layer was developed using a developer which was largely or entirely comprised of an organic solvent or solvents. The developer removed the unexposed (and unpolymerized) portions of the photoresist layer. Thus, organic solvents were used both for applying the photoresist composition to a substrate so as to form a photoresist layer, and organic solvents were utilized in the development step.

Safety and environmental concerns make it desirable to minimize or eliminate the use of organic solvents, when possible. A significant advance in photoresist technology was the development of aqueous-developable photoresists, e.g., those taught in U.S. Patents Nos. 3,887,450 and 3,953,309. Aqueous-developable photoresists eliminate or substantially eliminate the use of solvents in the development step. However, even aqueous-developable photoresists are conventionally applied to a blank board (or in the case of a dry film, to a polymeric support sheet) as a solution in a media that is substantially or entirely an organic solvent or solvents. There has been seen a need to provide water-borne photoimageable compositions for use as photoresists or the like.

There were some early waterbased photoresists based upon polyvinyl alcohol using Cr₂O₇ as a cross-linking agent. However, these systems are no longer used to any appreciable extent due to their instability.

A fully water-borne and aqueous-developable photoresisist is described by Y-C Chiou and J-M Liu in MRL Bull. Res. Dev., Vol. 2 No. 2 (1988) pp. 13-17. This photoimageable composition utilizes an emulsion polymer of acrylate and styrene as the binder material. As is conventional, the photoimageable composition layer also comprises photopolymerizable monomers and photoinitiators as well as conventional additives, such as thermal polymerization inhibitors and dyes. In attempting to follow the teachings of this reference, applicants have found that a poor quality photoresist results. In particular, it is found that photoresists prepared in accordance with that reference had poor wetting properties on copper surfaces. This results in problems, such as cratering and dewetting.

There exists a need for improved, water-borne, aqueous developable photoimageable compositions.

### SUMMARY OF THE INVENTION

In a photoimageable composition in accordance with the present invention, the components are borne in an aqueous medium that may be substantially free of organic solvent. The photoimageable composition in accordance with this invention is also developable in an aqueous medium, particularly an alkaline aqueous medium, that is substantially free of organic solvent. The photoimageable composition comprises polymeric binder, photopolymerizeable monomers and/or oligomers and photoinitiators. The polymeric binder comprises emulsion polymers in which the polymers are maintained by a surfactant within discrete micelles and also comprises solution polymers which are rendered water-soluble by the formation of salts of the polymer with ammonia or volatile amines. The inclusion of water-solubilized solution binder polymers along with the emulsion binder polymers improves the ability of the photoimageable composition to wet metals, such as copper, improves developing speed, and improves stripping speed. The water-solubilized solution binder polymers also enhance the ability of the photoimageable composition layers to be applied to a surface by advanced methods, such as curtain coating.

### DETAILED DESCRIPTION OF CERTAIN PREFERRED EMBODIMENTS

The polymers which comprise the binder material, including the emulsion polymers and the water-solubilized solution polymers, are selected so as to form a film or layer on a substrate, such as a copper-clad board or, in the case of a dry film, originally on a polymeric support sheet. The photoimageable compositions in accordance with the present invention are intended to be developable in solutions which are aqueous and which may be substantially free of organic solvent. To achieve these goals, reference may be had to above-identified U.S. Patents Nos. 3,887,450 and 3,953,309 which teach how binders polymers, formed from a mixture of monomers that provide an appropriate balance of carboxylic acid functionality and less polar functionality, render photoimageable compositions developable in aqueous solutions, particularly dilute alkaline aqueous solutions. The carboxylic acid functionality of such binders form salts with alkalis, thereby rendering such polymers soluble in dilute aqueous solutions. Both the emulsion polymers and the solution polymers used in accordance with the present invention utilize monomers that provide carboxylic acid functionality and monomers that provide less polar functionality The molecular weights (number average) of the emulsion binder polymers are preferably between about 200,000 and about 250,000. The molecular weights (number average) of the solution binder polymers are preferably between about 100,000 and about 200,000.

Suitable alpha,beta-ethylenically unsaturated monomers for forming both the emulsion binder polymers and the solution binder polymers include, but are not limited to acrylic acid and substituted acrylic acid, such as methacrylic acid and ethacrylic acid; esters of acrylic acids, such as methyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrlate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene.

The alpha, beta-ethylenically unsaturated functionality may also be provided in whole or in part, by short chain oligomers, such as oligomers containing multiple acrylate functionality.

The art of forming emulsion polymers is well established. The above-referenced article of Chiou and Liu, for example, teaches how to form emulsion polymers which are useful in accordance with the present invention. Suitable emulsion polymers are also commercially available. In order that the emulsion polymers remain in discrete micelles in the presence of other components of the photoimageable composition, it is preferred that the emulsion polymers comprise a substantial proportion of monomers, such as styrene or 2-methyl styrene, which provide substantial non-polar functionality. On the other hand, the emulsion polymers must also contain a high degree of carboxylic acid funcionality, in order that the photoimageable composition may be developable in alkaline aqueous solution. For purposes of the present invention, the emulsion polymers in accordance with the invention should have acid numbers of between about 50 and about 175.

Because emulsion polymers are formed within an aqueous solution in the presence of a surfactant or surfactants that are necessary to arrange the polymers into micelles, the photoimageable composition will contain such surfactants as a component of the micelles. Typically, the surfactant comprises between about 1 and about 5 parts per hundred resin relative to the emulsified polymer or between about 0.5 and about 3.0 parts per hundred resin relative to the total amount of binder polymer (emulsion polymer plus water-solubilized solution polymer). The photoimageable composition may also contain other chemicals or residues of chemicals used in the emulsion polymerization, such as ammonium persulfate and sodium metabisulfite.

An important aspect of the present invention is the inclusion of solution polymers in addition to the emulsion polymer. One function of the solution polymer component is to stabilize the emulsion of emulsion polymer. Regardless of the method of applying the photoimageable composition in liquid form to a substrate, the composition is passed through pumps that tend to coagulate emulsions; the solution polymer acts to prevent such coagulation of the emulsion polymer. The solution polymer also acts as an emulsifier for other non-water-soluble components and, in fact, improves micelle formation relative to many conventional surfactants. The solution polymer also aids wetting out at high speeds, e.g., in the range of 80 meters per second.

The solution polymers used in accordance with the invention are of the type heretofore used in the type described in above-referenced U.S. Patents Nos. 3,887,450 and 3,953,309. These polymers, due to their carboxylic acid functionality, are soluble in alkaline aqueous solutions (due to salt formation at the carboxylic acid sites). Solution polymers useful in accordance with the present invention have carboxylic acid functionality so as to achieve an acid number of between about 100 and about 250.

The acid functionality of the binder polymers enables the photoimageable composition to be developed in alkaline aqueous solution, such as dilute sodium carbonate. On the other hand, in neutral or acidic aqueous media, the binder polymers are generally insoluble. In fact it is a desirable characteristic of binder polymers, as components of a photoimageable composition layer on a substrate (such as on a copper-clad board or as a layer of a dry film), to be water-insoluble at neutral or acidic pH's.

In order to provide a water-borne photoimageable composition in accordance with the present invention, it is necessary to solubilize the solution polymer. This is accomplished in accordance with the present invention by dissolving the solution polymer in an aqueous medium containing ammonia or a volatile amine. The ammonia or volatile amine forms a salt with the carboxylic acid groups of the polymer, rendering the polymer water-soluble. After the photoimageable composition layer has been applied to a substrate, such as a copper-clad board or a polyester support sheet, a drying step which removes the water from the photoimageable composition layer also drives away the free ammonia or the volatile amine, resulting in water-insoluble binder polymer The ammonia necessary to solubilize the solution polymer in water may vary from polymer to polymer, but is usually provided at at least an equal molar amount relative to the carboxylic acid functionality of the solution polymer. Airborne ammonia, at low concentrations is not an environmental hazard. Volatile amines can be easily captured by carbon bed absorption.

Of the total amount of binder polymer, between about 10 and about 50 wt. percent is solution polymer, between about 50 and about 90 wt. percent is emulsion polymer.

To produce the image, this negative-acting photoimageable composition contains photopolymerizable monomers, particularly alpha,beta-ethylenically unsaturated monomers, including a substantial portion of multi-functional monomers. The monomers .include monomers, such as those used to form the binder polymers listed above. Particularly suitable monomers include multi-functional acrylic monomers, such as tetraethylene glycol diacrylate (TEGDA), trimethylol propane triacrylate (TMPTA), butanediol dimethacrylate (BDDMA) and pentaerythritol triacrylate (PETA). The monomers are used at a level of between about 40 and about 80 parts per hundred resin (phr) relative to the total amount of binder polymers (emulsion and solution).

Photopolymerizable oligomers may be substituted for a portion of or even all of the photopolymerizable monomers. This is particularly the case when the photoimageable composition is intended to be hardened in a cure step subsequent to exposure and development to form a solder mask. Example of photopolymerizable oligomers include bisphenol A epoxy acrylate and carboxylated bisphenol A.

It appears desirable in some cases to include a high proportion of monomers having ether functionality, particularly methoxy, ethoxy and propoxy functionality. Monomers that are solid at ambient temperatures, such as tris-(trihydroxyethyl)-isocyanurate triacrylate and carboxylated epoxy acrylate may be included to promote non-tacky surface areas of a photoimageable composition. Non-tacky photoimageable compositions are desirable if artwork is to be placed directly on the photoimageable composition.

To initiate polymerization of the monomers upon exposure to actinic radiation, the photoimageable composition contains an appropriate photoinitiator(s), such as 2-isopropyl thioxanthone. Photoinitiator(s) is used at a level of between about 0.1 and about 10 phr relative to the total amount of binder polymers (emulsion plus solution polymers).

The photoimageable composition will generally contain additives conventional in the art, such as fillers, dyes, flow control agents, thermal polymerization inhibitors, etc.

In accordance with a preferred embodiment of the invention, the photoimageable compositions include benzotriazole and/or carboxy benzotriazole, most preferably a mixture of benzotriazole and carboxyl benzotriazole. Benzotriazoles appear to function as developing aids. Benzotriazole and/or carboxy benzotriazole are used in accordance with the present invention at a combined level of up to about 1.0 phr relative to the binder polymers, preferably between about 0.1 and about 1.0 phr.

Water-borne photoresist compositions are provided in accordance with the invention in order to reduce volatile organic emmissions. Nevertheless, the compositions usually contain some volatile organic compounds, although compositions in accordance with the present invention may contain less than about 5 wt. % volatile organics. Volatile organics, such as ethoxy ethyl propionate, are desirably used as coalescing agents. Furthermore, the water-borne photoimageable compositions of the present invention are not necessarily incompatible with organic solvents, and it is not considered a departure from the practice of the invention merely to add some organic solvent to a photoimageable composition which is inherently being water-borne in accordance with the invention.

Photoimageable compositions in accordance with the present invention may be prepared in two parts. One part may be the aqueous emulsion of emulsion polymer. The other part initially contains the remainder of the components. Ammonia or volitile amine salt is added to water and the solution polymer is dissolved therein. The remaining components may then be dissolved in this solution. Subsequently, the water-borne emulsion polymer is added to the solution. The ratio of total solids in the emulsion polymer to the total solids in the aqueous solution is typically between about 1.5:1 and about 7.5:1.

Alternatively, the solution and emulsion polymers may be first premixed along with the ammonia or volatile amine. Then the rest of the ingredients are added to this mixture.

The final water-borne composition is between about 20 and about 40 wt. percent solids. In the water-borne composition, it is believed that the emulsion polymer remains as discrete micelles within the aqueous solution of the solution polymer. However, when added to the remainder of the components, the cloudiness of the emulsion disappears. This indicates that the micelles are reduced in size to micromicelles.

One particular advantage of the water-borne composition of the present invention, which contains water-solubilized solution polymer in addition to emulsion polymer, is that the composition may be coated by any of the coating systems known in the art for coating solvent-borne photoimageable compositions, such as roll coating, dip coating, spray coating or curtain coating.

The compositions of the present invention are applied in a conventional manner, either as liquid compositions directly to a metal clad blank laminate or to a polymeric support sheet to form a dry film. After coating, the composition is dried to remove water and also to remove ammonia, thereby rendering the solution polymer insoluble in acidic or neutral aqueous medium. As the photoimageable composition dries, the system coalesces into a continuous film. Drying is carried out at somewhat elevated temperatures, both to hasten removal of the water, and to drive off the ammonia or volatile amine. Preferably, drying is carried out at a temperature of about 90°C.

In forming a dry film, a water-borne composition is applied to flexible support sheet, e.g., polyethylene terephthalate, and then dried to remove water and volatiles. Subsequently, a protective sheet, e.g., polyethylene, is applied to the photoimageable composition layer, and the dry film is rolled into reels. In drying the photoimageable composition layer, it is found desirable in some cases, to leave a residual water content of between about 1 and about 2 wt. % (relative to solids of the photoimageable composition layer). This residual water acts to allow the photoimageable composition layer to conform to surface defects of a substrate, e.g., a copper-clad board, when laminated thereto.

Processing is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removeable. After development, an etchant may be used to remove copper from those areas where the resist was removed, thereby forming a printed circuit. The remaining resist is then removed using an appropriate stripper.

Not only can water-borne primary imaging photoresists be provided in accordance with the invention, but solder mask-forming compositions can be provided as well. By solder mask is meant herein a hard, permanent layer which meets at least the minimal requirements of the abrasion resistance tests as defined in IPC-SM-840B, Table 12, Summary of Criteria for Qualification/Conformance (Institute for Interconnecting Circuits). To become hard and permanent, it is generally necessary that the photoimageable composition be curable after exposure, development and processing of the board, e.g., by thermal and/or UV curing. One way to provide a post-cure is to provide binder polymer having free -OH groups in the backbone that may be cured, for example, by cross-linking with aminoplast resins, such as melamine/formaldehyde resins and urea/formaldehyde resins. Alternatively, the photoimageable composition may contain a compatible epoxy resin and a curative for the epoxy resin. It is found that water-borne photoimageable compositions in accordance with the invention exhibit excellent shelf lives after application to copper substrates and can remain on a copper-clad board upwards of several days.

The invention will now be described in greater detail by way of specific example.

### EXAMPLE 1

The following is a lab protocol for preparation of the emulsion polymer designated R-E029 in Example 2.

### I. Preparation of Pre-Emulsified Feed Mix:

### A. Aqueous Phase (Solution A) :

Sparge Feed Mix Tank (5 liter Round Bottom resin flask with bottom portion) with nitrogen gas for about 15 minutes. Then charge with gentle stirring the following: D.I. Water (750.0g), Alcolac's "Abex JKB" Anionic Surfactant (As-is: 30% solids - 190.0g), and more D.I water (500.0g) to quantitatively rinse all the surfactant into the feed mix tank.

### B. Oil Phase (Solution B) :

Into an appropriate erlenmeyer flask (3 liter) is weighed methyl methacrylate (918.0g), n-butyl acrylate (408.0g), styrene (290.0g), Aldrich's n-dodecanethiol (6.000g), and methacrylic acid (384.0g). Upon mixing this solution, it is sparged with nitrogen gas for about 15 minutes.

### C. Feed Mix:

The feed mix is prepared in an appropriate round bottom flask with a stopcocked drop leg (5 liter). The oil phase (Solution B) is added to the aqueous phase (Solution A) in the feed mix tank while stirring to yield good mixing without air/nitrogen entrainment (Talboy stirrer at maximum setting and variac at a setting of 35). This mixture is stirred for at least 20 minutes to yield the pre-emulsified feed mix.

### II. Preparation of Initiator Solution:

Into an appropriate erlenmeyer flask (125 ml.) is weighed ammonium persulfate (10.000g) and D.I. water (50.0g). The mixture is stirred to yield a homogeneous solution.

### III. Initial Reactor Charge:

Sparge the Reactor (5 liter round bottom 3 neck flask) with Nitrogen gas for about 15 minutes. Then charge D.I. water (590.3g) and heat to 70°C using a water bath.

### IV. Emulsion Polymerization:

After the initial reactor charge has stabilized at 70-71°C, a portion of the feed mix (250.0g) is charged to the reactor. This is followed by a rinse of D.I. water (500.0g). With continued stirring, the reactor contents are then heated back to 70°C. Upon re-attaining 70°C, the "Initiator Solution" is charged to the reactor. Monitor the reaction for an exotherm which should occur within 1 to 5 minutes. Cool the bath to keep the reaction temperature from exceeding 80°C. Ten minutes after adding the initiator solution, start the feed mix addition using a metering pump. Continue to cool the polymerization to bring the temperature back to within 70 - 74°C. During the 180 minute feed mix addition period, the reaction temperature should stabilize and line out between 70 and 74°C. Upon completion of the feed mix addition, the feed mix tank and metering pump are rinsed with D.I. water (50.0g). This rinse is charged to the reactor. The reactor contents are stirred at 70 - 74°C for one more hour. The resulting dispersion is then heated to 80 to 85°C and maintained at this temperature for two hours to deplete the remaining residual persulfate. The resulting dispersion polymer is then cooled to 50°C with a cool water bath, and then to ambient with an ice/water bath.

### V. Work-up of Dispersion Polymer:

The reaction mixture is then filtered through a 200 mesh fabric filter screen to collect the coagulum. Upon drying this collected solid is weighted to determine the percent of coalgulum formed.

The filters Dispersion copolymer is then packaged in glass bottles, sealed and labelled.

### EXAMPLE 2

A photoimageable composition was prepared containing the following components:

| Component | wt % | solids gm |
|---|---|---|
| R-EO29, Emulsion Polymer (Ex. 1) | 24.86 | 2476.43 |
| Water | 47.06 | |
| Ammonia | 4.05 | |
| XPD-1250, styrene/acrylic solution polymer, Mw 3000-6000 (B.F. Goodrich). | 6.21 | 1391.00 |
| BTC, Benzotriazole, | .03 | 7.00 |
| TPPN, Triphenyl Phosphene, initiator | .24 | 52.75 |
| ETHOX TMPTA, Ethoxylated Trimethylol Propane Triacrylate (Rad Cure) | 6.16 | 1380.00 |
| P4127, monomer (Henkel) | 6.16 | 1380.00 |
| Baso Blue 688, dye | .03 | 7.30 |
| ITX, initiator | .16 | 36.00 |
| QEPD, initiator | .83 | 185.00 |
| TMPTA, Trimethylol Propane Triacrylate (Rad Cure) | .49 | 110.00 |
| Modaflow (100%), flow control agent (Monsanto) | .05 | 10.60 |
| AO-2246 | .01 | 3.20 |
| Propylene glycol monomethyl ether (PM) coalescing agent | 3.55 | |
| FC-129, (3-M) fluorinated surfactant (helps maintain micelles) wetting/leveling agent | .04 | 8.00 |
| BYK-035, Paraffin-Based Mineral Oil (defoamer, surfactant) | .05 | 11.90 |

All of the above ingredients, except the emulsion polymer were mixed together to form a solution. Next, the emulsion polymer was added.

Processing conditions for this photoimageable composition are as follows:

| | |
|---|---|
| Drawdown: | Myer Bar - 50, 0.9 mil dry thickness |
| Dry: | 80°C, 16 minutes |
| Expose: | 120 mJ/cm², |
| Develop: | 1% Na₂CO₃·H₂O, 85°F |
| U.V. Cure: | 4 J/cm2 |
| Thermal Cure: | 150°C, 1 hour. |

### EXAMPLE 3

A solder mask-forming photoimageable composition in accordance with the invention is formulated as follows:

| Composition | Wt.(g) |
|---|---|
| Monomers | |
| Ethoxylate TMPTA | 8.00 |
| TMPTA | 4.00 |
| Bisphenyl A diacrylate | 3.00 |
| Pentaerythritol pentacrylate | 9.00 |

| Photoinitiators | |
|---|---|
| ITX | 1.00 |
| I 907 | 3.00 |
| I 651 | 1.00 |

| Pigment | |
|---|---|
| Pen Chips | 1.00 |

| Thermal Cross-linkers (all Monsanto) | |
|---|---|
| AM1142 (photosensitive melamine formaldehyde resin) | 8.50 |
| Resamine 755 (thermal curable malamine formaldehyde resin) | 5.00 |

| Oligomers (multi-acrylate functionality) | |
|---|---|
| Ebecryl 3800 (carboxylated bisphenol A epoxy acrylate) | 10.00 |
| Ebecryl 3701 (bisphenol A epoxy acrylate) | 6.00 |

| Antioxidant | |
|---|---|
| AO 2246 | 0.15 |

| Adhesion Promotor | |
|---|---|
| BTR | 0.50 |

| Binders | |
|---|---|
| CM 1731-92 (Morton International) styrene/methacrylic, having pendant -OH groups | 150.00 |
| XPD 1250 (B.F. Goodrich) | 30.00 |

| Solvent | |
|---|---|
| Deionized Water | 100.00 |
| Total | 350.15 |

The cross-linkers of this formulation react with the pendant -OH groups of the binder to effect a final thermal cure that renders the material hard and permanent and thereby suitable as a solder mask.

Processing conditions for this photoimageable composition are as follows:

| | |
|---|---|
| Drawdown: | Myer Bar - 75, 1.5 mil (38.1 µm) dry thickness |
| Dry: | 80°C, 30 minutes |
| Expose: | 120 mJ/cm², |
| Develop: | 1 % Na₂CO₃·H₂0, 85°F (29.4°C) |
| U.V Cure: | 4 J/cm² |
| Thermal Cure: | 150°C, 1 hour. |

While the photoimageable compositions in accordance with the present invention have been described herein primarily in terms of their suitability as resists for forming printed circuit boards, it will be understood that these compositions may also be used as photoimageable compositions for other applications such as chemical milling and printing plate formation.

## Claims

1. A photoimageable composition comprising:
1) an emulsion binder polymer having a carboxylic acid functionality of between 50 and 175, said emulsion binder polymer comprising between 50 and 90 wt. percent of total binder polymer,
1a) surfactant sufficient to maintain said emulsion binder polymer in micelles when said photoimageable composition is borne in an aqueous medium,
2) a solution polymer having a carboxylic acid functionality of between 100 and 250, said solution binder polymer comprising between 10 and 50 wt. percent of total binder polymer,
2a) ammonia or a volatile amine compound sufficient to render said solution polymer soluble in aqueous solution,
3) photopolymerizable monomer(s), and/or oligomer(s), soluble in an aqueous solution of said solution binder polymer in an amount of between 40 and 80 phr relative to the total of said emulsion binder polymer and said solution polymer, and
4) a photoinitiator at a level of between 0.1 and 10 phr relative to the total of said emulsion binder polymer and said solution polymer.

2. A photoimageable composition according to Claim 1 further containing water in an amount sufficient to maintain micelles of said emulsion polymer.

3. A photoimageable composition according to Claim 1 or Claim 2 also containing benzotriazole and/or carboxy benzotriazole at a total level of between 0.1 and 1.0 phr relative to the total amount of said emulsion binder polymer plus said solution binder polymer.
